# EUROPEAN PATENT SPECIFICATION

(11) **EP 4 535 413 B1**
(45) Date of publication and mention of the grant of the patent: **22.04.2026**
(21) Application number: 24202569.0
(22) Date of filing: 25.09.2024
(51) Int. Cl.: H10W 20/00, H10W 20/20, H10W 20/40, H10W 20/41, G11C 5/06

(54) **INTEGRATED CIRCUIT DEVICE AND METHOD OF MANUFACTURING THE SAME**
INTEGRIERTE SCHALTUNGSANORDNUNG UND VERFAHREN ZU DEREN HERSTELLUNG
DISPOSITIF DE CIRCUIT INTÉGRÉ ET SON PROCÉDÉ DE FABRICATION

(30) Priority: 04.10.2023 KR 20230131943
(43) Date of publication of application: 09.04.2025
(73) Proprietor: Samsung Electronics Co., Ltd., Suwon-si, Gyeonggi-do 16677 (KR)
(72) Inventor: NAM, Seowoo, 16677 Suwon-si (KR); SHIN, Heonjong, 16677 Suwon-si (KR); LEE, Sanghee, 16677 Suwon-si (KR)
(74) Representative: Marks & Clerk LLP

(56) References cited:
- US-A1- 2022 077 062

## Description

### FIELD

The inventive concept relates to an integrated circuit device and a method of manufacturing the same, and more particularly, to an integrated circuit device including a backside power distribution network (BSPDN) and a method of manufacturing the integrated circuit device.

### BACKGROUND

Advances in electronic technology have contributed to the rapid down-scaling of integrated circuit devices. In highly down-scaled integrated circuit devices, because high operating accuracy as well as a fast operating speed is desirable, a wiring structure having a stable and/or optimized structure may be needed in a relatively small area. To this end, integrated circuit devices including a power distribution network in a backside surface have been developed; however, improvements may still be necessary.
US 2022/0077062 A1 describes an integrated chip including a semiconductor device. The semiconductor device includes a gate structure overlying a front-side surface of a first substrate. The first substrate has a back-side surface opposite the front-side surface. A first source/drain structure overlies the first substrate and is laterally adjacent to the grate structure. A power rail is embedded in the first substrate and directly underlies the first source/drain structure. A first source/drain contact continuously extends from the first source/drain structure to the power rail. The first source/drain contact electrically couples the first source/drain structure to the power rail.

### SUMMARY

The inventive concept provides integrated circuit devices with a structure for enhancing the reliability of an electrical connection in the integrated circuit device, the structure including a device region having an area reduced based on down-scaling.

Embodiments of the inventive concept are not limited to the aforesaid, and other embodiments not explicitly described herein will be clearly understood by those of ordinary skill in the art from descriptions below.

The invention is defined in independent claims 1 and 10. Further preferred embodiments are defined in the dependent claims. Only embodiments of the description comprising all the technical features of the claims fall under the scope of protection of the claims while the remaining ones correspond to illustrative examples which are useful for the understanding of the relevant technical context.

### BRIEF DESCRIPTION OF THE DRAWINGS

Embodiments will be more clearly understood from the following detailed description taken in conjunction with the accompanying drawings in which:
FIG. 1 is a diagram illustrating a plan layout of a cell block of an integrated circuit device according to an embodiment;
FIG. 2 is a plan layout diagram illustrating an integrated circuit device according to an embodiment;
FIG. 3 is a cross-sectional view taken along line A-A' of FIG. 2;
FIG. 4 is a cross-sectional view taken along line B-B' of FIG. 2;
FIG. 5 is a cross-sectional view taken along line C-C' of FIG. 2;
FIG. 6 is an enlarged cross-sectional view of a region DD of FIG. 3;
FIGS. 7 and 8 are cross-sectional views illustrating an integrated circuit device according to another embodiment;
FIG. 9 is a flowchart illustrating a method of manufacturing an integrated circuit device, according to an embodiment;
FIGS. 10, 11, 12, 13, 14, 15, 16, 17, 18, 19, 20, 21, 22, 23, and 24 are diagrams illustrating a method of manufacturing an integrated circuit device in process sequence, according to an embodiment;
FIGS. 25 and 26 are cross-sectional views corresponding to an active pattern of an integrated circuit device, according to an embodiment; and
FIG. 27 is a block diagram illustrating a system including an integrated circuit device, according to an embodiment.

### DETAILED DESCRIPTION OF THE EMBODIMENTS

Hereinafter, embodiments will be described in detail with reference to the accompanying drawings. The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items. The term "connected" may be used herein to refer to a physical and/or electrical connection. When components or layers are referred to herein as "directly" on, or "in direct contact" or "directly connected," no intervening components or layers are present. Likewise, when components are "immediately" adjacent to one another, no intervening components may be present.

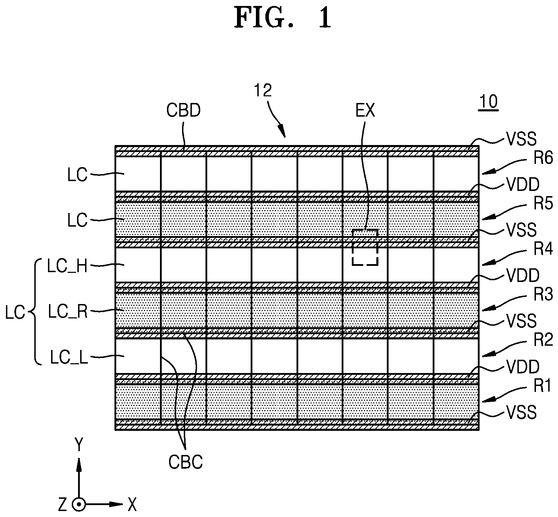

FIG. 1 is a diagram illustrating a plan layout of a cell block 12 of an integrated circuit device 10 according to an embodiment.

Referring to FIG. 1, the cell block 12 of the integrated circuit device 10 may include a plurality of logic cells LC including circuit patterns for configuring various circuits.

The plurality of logic cells LC may be arranged in a matrix form in a first horizontal direction (e.g., an X direction) and a second horizontal direction (e.g., a Y direction) in the cell block 12.

The plurality of logic cells LC may include a circuit pattern having a layout designed based on place and route (PnR) technique so as to perform at least one logic function. The plurality of logic cells LC may have a function of performing various logic functions. In some embodiments, each of the plurality of logic cells LC may include a plurality of standard cells. In some embodiments, at least some of the plurality of logic cells LC may perform the same logic function. In other embodiments, at least some of the plurality of logic cells LC may perform different logic functions.

The plurality of logic cells LC may include various logic cells each including a plurality of circuit elements. For example, each of the plurality of logic cells LC may be configured to implement AND, NAND, OR, NOR, exclusive OR (XOR), exclusive NOR (XNOR), inverter (INV), adder (ADD), buffer (BUF), delay (DLY), filter (FIL), multiplexer (MXT/MXIT), OR/AND/INVERTER (OAI), AND/OR (AO), AND/OR/INVERTER (AOI), D flip-flop, reset flip-flop, master-slave flip-flop, latch, or a combination thereof, but is not limited thereto.

In the cell block 12, at least some of a plurality of logic cells LC configuring one row R1, R2, R3, R4, R5, or R6 may have the same width in the first horizontal direction (the X direction). Also, the at least some of the plurality of logic cells LC configuring the one row R1, R2, R3, R4, R5, or R6 may have the same height. However, the inventive concept is not limited to the illustration, and the at least some of the plurality of logic cells LC configuring the one row R1, R2, R3, R4, R5, or R6 may have different widths and heights.

An area of each of the plurality of logic cells LC included in the cell block 12 of the integrated circuit device 10 may be defined by a cell boundary CBD. A cell boundary contact portion CBC where cell boundaries CBD contact each other may be provided between two adjacent logic cells LC in the first horizontal direction (the X direction) or the second horizontal direction (the Y direction) among the plurality of logic cells LC.

In some embodiments, two logic cells LC adjacent to each other in a width direction among the plurality of logic cells LC configuring the one row R1, R2, R3, R4, R5, or R6 may contact each other at the cell boundary contact portion CBC without a separation distance. In other embodiments, two logic cells LC adjacent to each other in the width direction among the plurality of logic cells LC configuring the one row R1, R2, R3, R4, R5, or R6 may be spaced apart from each other by a separation distance.

In some embodiments, two logic cells LC adjacent to each other among the plurality of logic cells LC configuring the one row R1, R2, R3, R4, R5, or R6 may perform the same function. In this case, two logic cells LC adjacent to each other may have the same structure. In other embodiments, two logic cells LC adjacent to each other among the plurality of logic cells LC configuring the one row R1, R2, R3, R4, R5, or R6 may perform different functions.

In some embodiments, one logic cell LC selected from among the plurality of logic cells LC included in the cell block 12 of the integrated circuit device 10 and the other logic cell LC adjacent to the selected logic cell LC in the second horizontal direction (the Y direction) may have a symmetrical structure with respect to a cell boundary contact portion CBC therebetween. For example, a reference logic cell LC_R of a third row R3 and a lower logic cell LC_L of a second row R2 may have a symmetrical structure with respect to a cell boundary contact portion CBC therebetween. Also, the reference logic cell LC_R of the third row R3 and an upper logic cell LC_H of a fourth row R4 may have a symmetrical structure with respect to a cell boundary contact portion CBC therebetween.

A cell block 12 including six rows R1 to R6 is illustrated in the drawing, but this may be merely an embodiment and the cell block 12 may include a various number of rows selected depending on the case and one row may include a various number of logic cells selected depending on the case.

One line selected from among a plurality of ground lines VSS and a plurality of power lines VDD may be disposed between two adjacent rows of a plurality of rows R1 to R6 each including a plurality of logic cells LC arranged in one row longitudinally extending in the first horizontal direction (the X direction). The plurality of ground lines VSS and the plurality of power lines VDD may each extend in the first horizontal direction (the X direction) and may be alternately arranged and spaced apart from each other in the second horizontal direction (the Y direction). Therefore, each of the plurality of ground lines VSS and the plurality of power lines VDD may be disposed to overlap a cell boundary CBD of a corresponding logic cell LC in the first horizontal direction (the X direction). Components or layers described with reference to "overlap" in a particular direction may be at least partially obstructed by one another when viewed along a line extending in the particular direction or in a plane perpendicular to the particular direction. In other words, components may partially overlay each other.

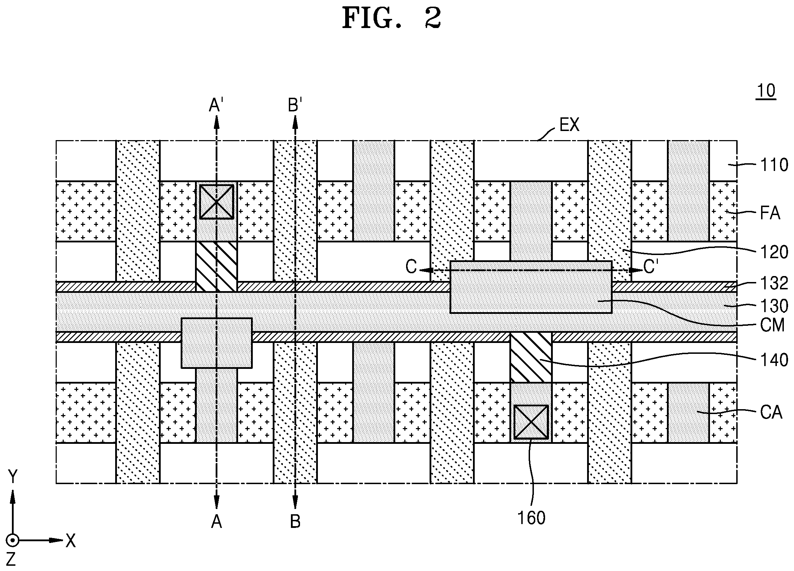

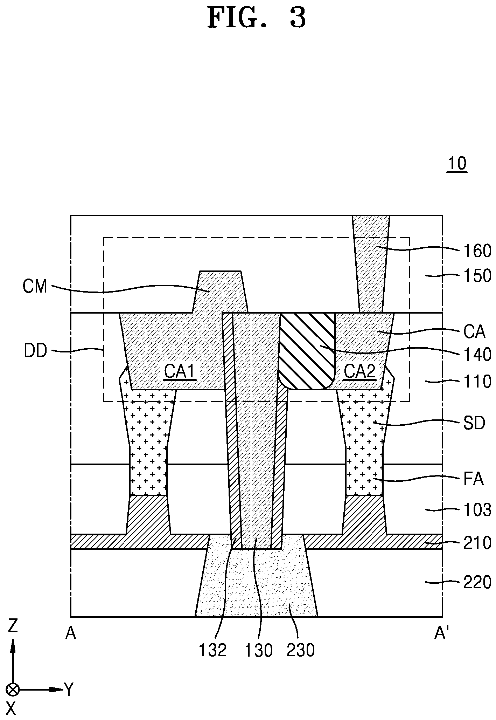

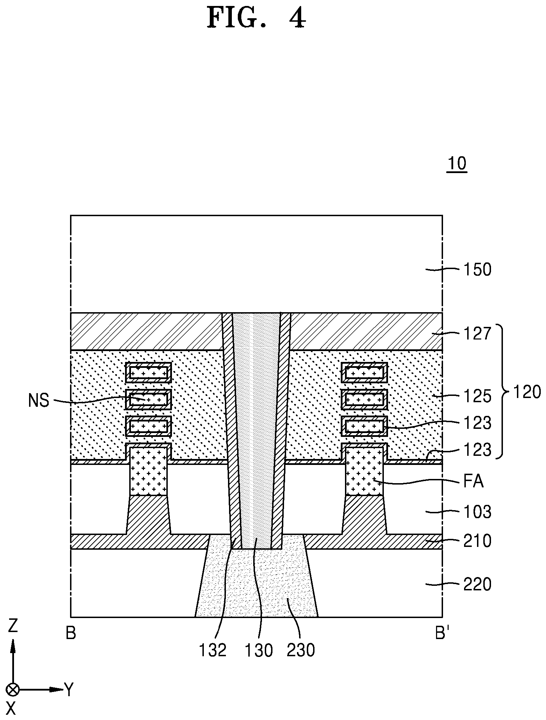

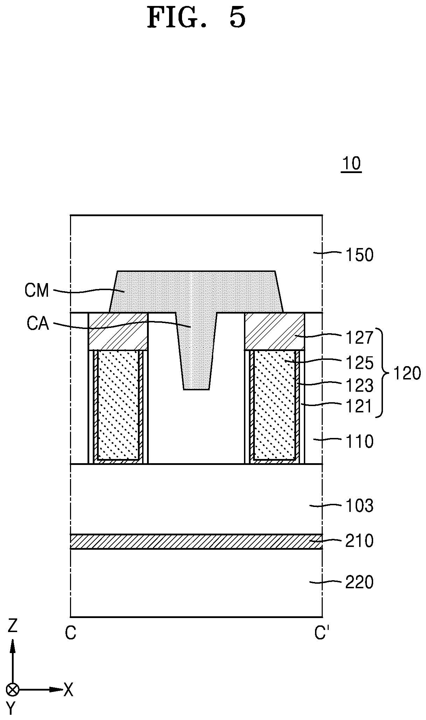

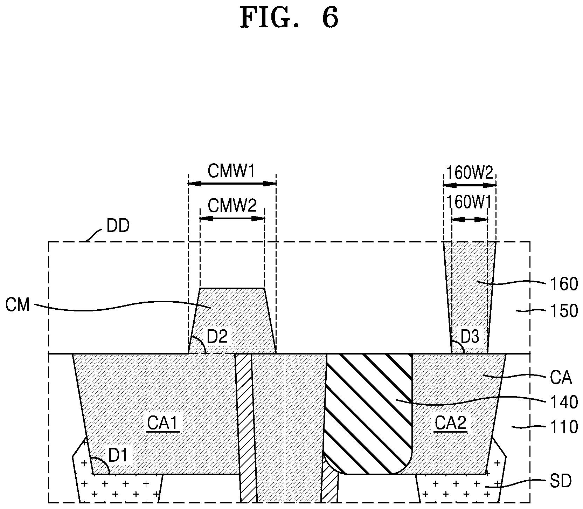

FIG. 2 is a plan layout diagram illustrating an integrated circuit device 10 according to an embodiment. FIG. 2 shows a plan layout of some elements in a region EX of FIG. 1. FIG. 3 is a cross-sectional view taken along line A-A' of FIG. 2. FIG. 4 is a cross-sectional view taken along line B-B' of FIG. 2. FIG. 5 is a cross-sectional view taken along line C-C' of FIG. 2. FIG. 6 is an enlarged cross-sectional view of a region DD of FIG. 3.

Referring to FIGS. 2 to 6, the integrated circuit device 10 may include a pair of fin-type active regions FA adjacent to each other in a second horizontal direction (a Y direction) with a via power rail 130 therebetween.

The integrated circuit device 10 according to an embodiment may include the pair of fin-type active regions FA which respectively protrude from backside insulation structures 210 and 220 described below. The pair of fin-type active regions FA may extend long or longitudinally in a first horizontal direction (an X direction) on the backside insulation structures 210 and 220 and may be spaced apart from each other to extend in parallel in the second horizontal direction (the Y direction) perpendicular to the first horizontal direction (the X direction). A pair of fin-type active regions FA is illustrated in the drawing, but this may be merely an embodiment and the integrated circuit device 10 may include a various number of fin-type active regions FA selected depending on the case.

A device isolation layer 103 may be disposed to cover (i.e., disposed on) at least a portion of each of both (e.g., opposing) sidewalls of each of the pair of fin-type active regions FA. The device isolation layer 103 may be disposed to cover (i.e., on) at least a portion of each sidewall of each of the pair of fin-type active regions FA in the second horizontal direction (the Y direction). The device isolation layer 103 may include an insulating material, and for example, may include silicon oxide, but is not limited thereto.

A pair of source/drain regions SD may be disposed in the pair of fin-type active regions FA. That is, the pair of source/drain regions SD may be formed in a region where the pair of fin-type active regions FA are partially etched. The pair of source/drain regions SD may be on the pair of fin-type active regions FA in the vertical direction (the Z direction). In some embodiments, the pair of source/drain regions SD may each be a raised source/drain region. Therefore, upper ends of the pair of source/drain regions SD may be higher than upper ends of the pair of fin-type active regions FA, relative to the backside insulation structure 210, 220. It will be understood that spatially relative terms such as "above," "upper," "below," "lower," "under," "over," and the like may be denoted by reference numerals and refer to the drawings, except where otherwise indicated. It will be understood that such spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features.

An interlayer insulation layer 110 may be disposed on the pair of source/drain regions SD and the device isolation layer 103. The interlayer insulation layer 110 may be on the pair of source/drain regions SD and the device isolation layer 103 in the vertical direction (the Z direction) and/or second horizontal direction (Y direction). Also, the interlayer insulation layer 110 may be formed to contact an outer sidewall of each of a plurality of gate structures 120 described below. The interlayer insulation layer 110 may include an insulating material, and for example, may include at least one of silicon oxide, silicon nitride, silicon oxynitride, and a low-k dielectric material.

The plurality of gate structures 120 may extend longitudinally in the second horizontal direction (the Y direction) on the pair of fin-type active regions FA. A nanosheet stack NS may be disposed at an upper portion of each of the pair of fin-type active regions FA, in regions where the pair of fin-type active regions FA intersect with the plurality of gate structures 120. The nanosheet stack NS may be disposed at a position which is spaced apart from each of the pair of fin-type active regions FA in a vertical direction (e.g., a Z direction).

The term "nanosheet" used herein may denote a conductive structure including a cross-sectional surface which is substantially vertical to a direction in which a current flows. The nanosheet will be understood as including a nanowire.

The plurality of gate structures 120 may be spaced apart from one another in the first horizontal direction (the X direction) and may extend in the second horizontal direction (the Y direction). Also, the plurality of gate structures 120 may be disposed on the pair of fin-type active regions FA and the device isolation layer 103. The plurality of gate structures 120 may be disposed on the pair of fin-type active regions FA and the device isolation layer 103 in the vertical direction (the Z direction). Each of the plurality of gate structures 120 may include a gate spacer 121, a gate dielectric layer 123, a gate electrode 125, and a gate capping layer 127.

The gate spacer 121 may include, for example, silicon nitride. The gate spacer 121 may be formed by a process such as a chemical vapor deposition (CVD) process or an atomic layer deposition (ALD) process.

The gate dielectric layer 123 may be disposed between the gate electrode 125 and the fin-type active region FA, e.g., in the vertical direction (the Z direction). Also, the gate dielectric layer 123 may be disposed between the gate electrode 125 and the nanosheet stack NS, e.g., in the vertical direction (the Z direction). Also, the gate dielectric layer 123 may be disposed between the gate electrode 125 and the interlayer insulation layer 110, e.g., in the vertical direction (the Z direction). In some embodiments, the gate dielectric layer 123 may extend in the second horizontal direction (the Y direction) along a profile of the fin-type active region FA which protrudes upward from the device isolation layer 103. Also, the gate dielectric layer 123 may be disposed to surround the nanosheet stack NS, e.g., in the second horizontal (Y direction) and/or the vertical direction (the Z direction). The term "surround" or "cover" or "fill" as may be used herein may not require completely surrounding or covering or filling the described elements or layers, but may, for example, refer to partially surrounding or covering or filling the described elements or layers, for example, with voids or other spaces throughout.

In some embodiments, the gate dielectric layer 123 and the gate electrode 125 may be formed through a replacement metal gate process or a gate-last process. The gate dielectric layer 123 may include a high-k dielectric material having a dielectric constant which is higher than that of silicon oxide. For example, the gate dielectric layer 123 may include HfO, ZrO, LaO, AlO, or TaO.

The gate electrode 125 may have a single-layer structure or a multi-layer structure where two or more layers are stacked. In some embodiments, the gate electrode 125 may include a work function adjustment layer and a center electrode layer. The work function adjustment layer may perform a function of adjusting a work function, and the center electrode layer may fill a space which is formed by the work function adjustment layer. The work function adjustment layer may include, for example, at least one of TiN, WN, TiAl, TiAlN, TaN, TiC, TaC, TaCN, TaSiN, and a combination thereof. Also, the center electrode layer may include, for example, at least one of tungsten (W), aluminum (Al), cobalt (Co), titanium (Ti), tantalum (Ta), polysilicon (poly-Si), SiGe, and a metal alloy.

The gate capping layer 127 may be disposed on the gate electrode 125, e.g., in the vertical direction (the Z direction). In some embodiments, the gate capping layer 127 may be a self-aligned hard mask pattern, but is not limited thereto. The gate capping layer 127 may include, for example, silicon nitride.

A via power rail 130 may extend in the vertical direction (the Z direction) between the pair of fin-type active regions FA. The via power rail 130 may be disposed between the pair of fin-type active regions FA in the second horizontal direction (Y direction). The via power rail 130 may pass through the interlayer insulation layer 110 and the device isolation layer 103 in the vertical direction (the Z direction). The via power rail 130 may include, for example, molybdenum (Mo), copper (Cu), tungsten (W), cobalt (Co), ruthenium (Ru), manganese (Mn), titanium (Ti), tantalum (Ta), aluminum (Al), a combination thereof, or an alloy thereof, but is not limited thereto.

Both (e.g., opposing) sidewalls of the via power rail 130 may be surrounded by a rail insulation layer 132. The rail insulation layer 132 may include silicon oxide, silicon oxynitride, silicon nitride, or a combination thereof.

A pair of source/drain contacts CA may be disposed on the pair of source/drain region SD, e.g., in the vertical direction (the Z direction). Also, the pair of source/drain contacts CA may contact the pair of source/drain regions SD and may be disposed spaced apart from each other in the second horizontal direction (the Y direction) with the via power rail 130 therebetween. Furthermore, each of the pair of source/drain contacts CA may be spaced apart from the gate electrode 125 in the first horizontal direction (the X direction).

The pair of source/drain contacts CA may include, for example, Mo, Cu, W, Co, Ru, Mn, Ti, Ta, Al, a combination thereof, or an alloy thereof, but is not limited thereto.

In the integrated circuit device 10 according to an embodiment, the pair of source/drain contacts CA may include a first source/drain contact CA1 and a second source/drain contact CA2, which have different shapes. This will be described below in detail.

A contact-merged bridge CM may be disposed on (e.g., disposed on in the vertical direction (the Z direction)) and electrically connected to the first source/drain contact CA1 of the pair of source/drain contacts CA and the via power rail 130. That is, the first source/drain contact CA1 and the contact-merged bridge CM may be configured as a one-body structure or a unitary member where a boundary surface or interface is not formed therebetween. In other words, in some embodiments, the first source/drain contact CA1 and the contact-merged bridge CM may be integral to one another, which may also referred to as a unitary structure that is free of an interface therebetween.

As described below, this may be characterized based on a manufacturing process where the first source/drain contact CA1 and the contact-merged bridge CM are formed by a one-time etching process from the same material layer. Accordingly, in the integrated circuit device 100, the contact-merged bridge CM may include the same material as that of the pair of source/drain contacts CA described above.

An inner sidewall of the first source/drain contact CA1 may be disposed to contact the rail insulation layer 132. When seen in a cross-sectional view, the contact-merged bridge CM may have a trapezoid shape, and a bottom surface of the contact-merged bridge CM may be disposed to contact an upper surface of the via power rail 130 and an upper surface of the rail insulation layer 132. Based on such a structure, the first source/drain contact CA1 and the via power rail 130 may not contact each other at the same level (e.g., in the vertical direction (the Z direction)) and may be electrically connected with each other through the contact-merged bridge CM. As used herein, elements or contact therebetween at a same "level" may refer to a distance relative to an upper or lower surface of an illustrated structure.

Also, the bottom surface of the contact-merged bridge CM may be disposed spaced apart from an upper surface of the gate electrode 125 in the vertical direction (the Z direction). This may be characterized based on the gate capping layer 127 disposed on (e.g., in the vertical direction (the Z direction)) the upper surface of the gate electrode 125. Furthermore, when seen in a plan view, the contact-merged bridge CM may be formed not to overlap the pair of nanosheet stacks NS. In other words, the contact-merged bridge CM may be non-overlapping with the pair of nanosheet stacks NS.

A contact isolation insulation layer 140 may be disposed between the second source/drain contact CA2 of the pair of source/drain contacts CA and the via power rail 130 (e.g., in the second horizontal direction (the Y direction)). The contact isolation insulation layer 140 may be disposed between a pair of source/drain contacts CA adjacent to each other in the second horizontal direction (the Y direction) and may electrically disconnect or electrically isolate the pair of source/drain contacts CA from each other. Each contact isolation insulation layer 140 disposed between two adjacent gate electrodes 125 of a plurality of gate electrodes 125 may be disposed between the pair of source/drain contacts CA.

A portion of a sidewall of the via power rail 130 may contact the contact isolation insulation layer 140, and an inner sidewall of the second source/drain contact CA2 may be disposed to contact the contact isolation insulation layer 140. Also, an upper surface of the via power rail 130, an upper surface of the rail insulation layer 132, an upper surface of the contact isolation insulation layer 140, and an upper surface of the second source/drain contact CA2 may configure a coplanar surface. When seen in a cross-sectional view, the contact isolation insulation layer 140 and the contact-merged bridge CM may be disposed spaced apart from each other in the second horizontal direction (the Y direction).

The upper insulation layer 150 may be formed to cover (e.g., in the vertical direction (the Z direction)) both (e.g., opposing) sidewalls of the contact-merged bridge CM and an upper surface of each of the via power rail 130, the rail insulation layer 132, the contact isolation insulation layer 140, the pair of source/drain contacts CA, the contact-merged bridge CM, and the interlayer insulation layer 110. The upper insulation layer 150 may include, for example, silicon oxide, silicon nitride, an ultra low-k material having an ultra low dielectric constant K, or a combination thereof.

A via structure 160 may pass through the upper insulation layer 150 and may contact an upper surface of the second source/drain contact CA2. That is, the via structure 160 may be disposed on the second source/drain contact CA2 (e.g., in the vertical direction (the Z direction)). Accordingly, the source/drain region SD may be electrically connected with the via structure 160 through the second source/drain contact CA2. The via structure 160 may include, for example, Mo, Cu, W, Co, Ru, Mn, Ti, Ta, Al, a combination thereof, or an alloy thereof, but is not limited thereto.

In the integrated circuit device 10 according to an embodiment, an angle between a bottom surface and a sidewall of the contact-merged bridge CM may be an acute angle, an angle between a bottom surface and a sidewall of the via structure 160 may be an obtuse angle, and an angle between a bottom surface and an outer sidewall of each of the pair of source/drain contacts CA may be an obtuse angle. As used herein, outer sidewalls may be opposite to inner sidewalls of the pair of source/drain contacts CA, where the inner sidewalls may face one another. In other words, a horizontal width CMW1 of the bottom surface of the contact-merged bridge CM may be greater than a horizontal width CMW2 of an upper surface of the contact-merged bridge CM, and/or a horizontal width 160W1 of the bottom surface of the via structure 160 may be less than a horizontal width 160W2 of an upper surface of the via structure 160. As described below, this may be characterized based on a manufacturing process where the first source/drain contact CA1 and the contact-merged bridge CM are formed by a one-time or same etching process, but embodiments of the inventive concept are not limited thereto.

The backside insulation structures 210 and 220 may be disposed under (e.g., in the vertical direction (the Z direction)) the pair of fin-type active regions FA. The backside insulation structures 210 and 220 may include an upper backside insulation structure 210 including a protrusion portion and a lower backside insulation structure 220 disposed on (e.g., in the vertical direction (the Z direction)) a lower surface of the upper backside insulation structure 210.

In some embodiments, the upper backside insulation structure 210 and the lower backside insulation structure 220 may include different insulating materials. Each of the upper backside insulation structure 210 and the lower backside insulation structure 220 may include, for example, different materials selected from among silicon oxide, silicon nitride, silicon carbide, and a low-k dielectric material. The low-k dielectric material may include fluorine-doped silicon oxide, organosilicate glass, carbon-doped oxide, porous silicon oxide, porous organosilicate glass, spin-on organic polymeric dielectric, spin-on silicon based polymeric dielectric, or a combination thereof.

A power rail wiring 230 may pass through the backside insulation structures 210 and 220 in the vertical direction (the Z direction) and may contact the via power rail 130. In some embodiments, the power rail wiring 230 may configure or may be configured to provide the ground line VSS illustrated in FIG. 1. The power rail wiring 230 may include a metal wiring layer and a conductive barrier layer surrounding the metal wiring layer. Here, the metal wiring layer may include, for example, Mo, W, Co, Ru, Mn, Ti, Ta, Al, Cu, a combination thereof, or an alloy thereof. The conductive barrier layer may include, for example, Ti, Ta, W, TiN, TaN, WN, WCN, TiSiN, TaSiN, WSiN, or a combination thereof.

Advances in electronic technology have resulted in rapid down-scaling of integrated circuit devices. In highly down-scaled integrated circuit devices, because operating accuracy as well as a fast operation speed is desired, it may be required to provide a wiring structure having a stabilized and optimized structure in a relatively small area. To this end, the integrated circuit device 10 including a backside power distribution network (BSPDN) is being developed.

Generally, in a manufacturing process of the integrated circuit device 10 including the BSPDN, a process of removing a portion of the rail insulation layer 132 disposed at a sidewall of the via power rail 130 may be performed for electrical connection between the via power rail 130 and the source/drain contact CA. However, in a process of forming the via power rail 130 and the source/drain contact CA, a manufacturing process of removing only a portion of the rail insulation layer 132 disposed therebetween without affecting the other elements may be difficult. Due to this, problems caused by a process error may occur.

To solve such problems, in the integrated circuit device 10 according to an embodiment, the contact-merged bridge CM may be provided as one body (i.e., as an integral structure or unitary member) on the source/drain contact CA, and a process of removing only a portion of the rail insulation layer 132 may not be performed, thereby reducing difficulty and/or complexity of a manufacturing process. That is, the source/drain contact CA and the via power rail 130 may not contact each other at the same level (e.g., the same level in the vertical direction (the Z direction)), based on the rail insulation layer 132, and may be electrically connected with each other through the contact-merged bridge CM, for example, at a top or upper surface of the via power rail 130 (rather than at a side surface or sidewall thereof).

As a result, in the integrated circuit device 10 according to an embodiment, in a structure including the BSPDN for a device region having an area reduced based on down-scaling, a partial etching process of the rail insulation layer 132 (which may be high in level of difficulty of a manufacturing process) may be omitted and may be replaced with a process of forming the contact-merged bridge CM, and thus, a level of difficulty and/or complexity of a manufacturing process may be reduced and/or electrical characteristics may be enhanced.

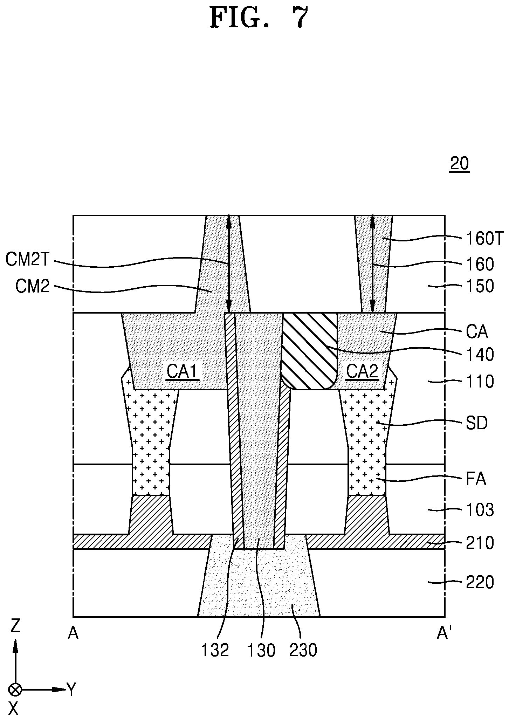

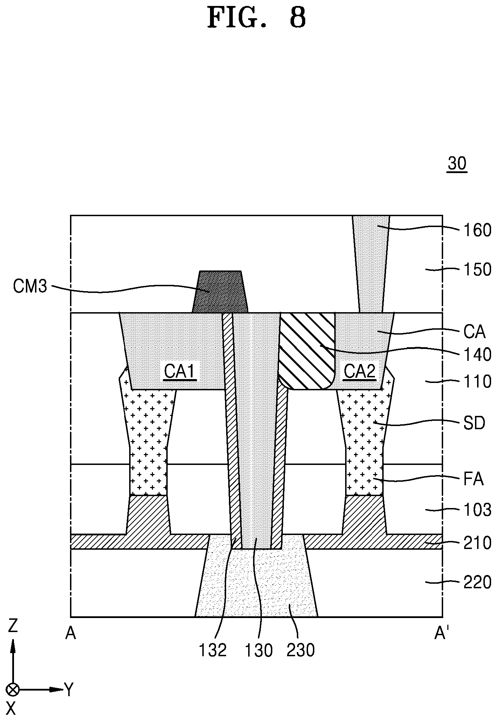

FIGS. 7 and 8 are cross-sectional views illustrating an integrated circuit device according to another embodiment.

Most elements configuring integrated circuit devices 20 and 30 described below and materials of the elements may be substantially the same as or similar to the descriptions of FIGS. 2 to 6. Therefore, for convenience of description, differences with the integrated circuit device 10 described above will be mainly described below.

Referring to FIG. 7, an integrated circuit device 20 according to another embodiment may include a pair of source/drain contacts CA including a contact-merged bridge CM2 and a via structure 160.

In the integrated circuit device 20 according to another embodiment, the contact-merged bridge CM2 may be disposed on a via power rail 130 and a first source/drain contact CA1 of the pair of source/drain contacts CA. That is, the first source/drain contact CA1 and the contact-merged bridge CM2 may be configured as a one-body or unitary structure where a boundary surface or interface is not formed therebetween. That is, in some embodiments, the first source/drain contact CA1 and the contact-merged bridge CM may be free of an interface therebetween.

In the integrated circuit device 20 according to another embodiment, the via structure 160 may pass through an upper insulation layer 150 and may contact an upper surface of a second source/drain contact CA2. That is, the via structure 160 may be disposed on the second source/drain contact CA2. Accordingly, the source/drain region SD may be electrically connected with the via structure 160 through the second source/drain contact CA2.

In the integrated circuit device 20 according to another embodiment, a thickness CM2T of the contact-merged bridge CM2 in a vertical direction (a Z direction) may be substantially equal to a thickness 160T of the via structure 160 in the vertical direction (the Z direction). In other words, a level of a bottom surface of the contact-merged bridge CM2 may be substantially equal to or coplanar with that of a bottom surface of the via structure 160, and a level of an upper surface of the contact-merged bridge CM2 may be substantially equal to or coplanar with that of an upper surface of the via structure 160.

Referring to FIG. 8, an integrated circuit device 30 according to another embodiment may include a pair of source/drain contacts CA including a contact bridge CM3 and a via structure 160.

In the integrated circuit device 30 according to another embodiment, the contact bridge CM3 may be disposed on a via power rail 130 and a first source/drain contact CA1 of the pair of source/drain contacts CA. That is, the first source/drain contact CA1 and the contact bridge CM3 may be configured as different structures where a boundary surface or interface is formed therebetween. This may be characterized based on a manufacturing process where the first source/drain contact CA1 and the contact bridge CM3 are formed by different etching processes from different material layers. Accordingly, in the integrated circuit device 30, the contact bridge CM3 may include a material which differs from a material of the pair of source/drain contacts CA, but is not limited thereto.

In the integrated circuit device 30 according to another embodiment, an inner sidewall of the first source/drain contact CA1 may be disposed to contact a rail insulation layer 132. When seen in a cross-sectional view, the contact bridge CM3 may have a trapezoid shape, and a bottom surface of the contact bridge CM3 may be disposed to contact an upper surface of the first source/drain contact CA1, an upper surface of the via power rail 130, and an upper surface of the rail insulation layer 132. Based on such a structure, the first source/drain contact CA1 and the via power rail 130 may not directly contact each other at the same level and may be electrically connected with each other through the contact bridge CM3.

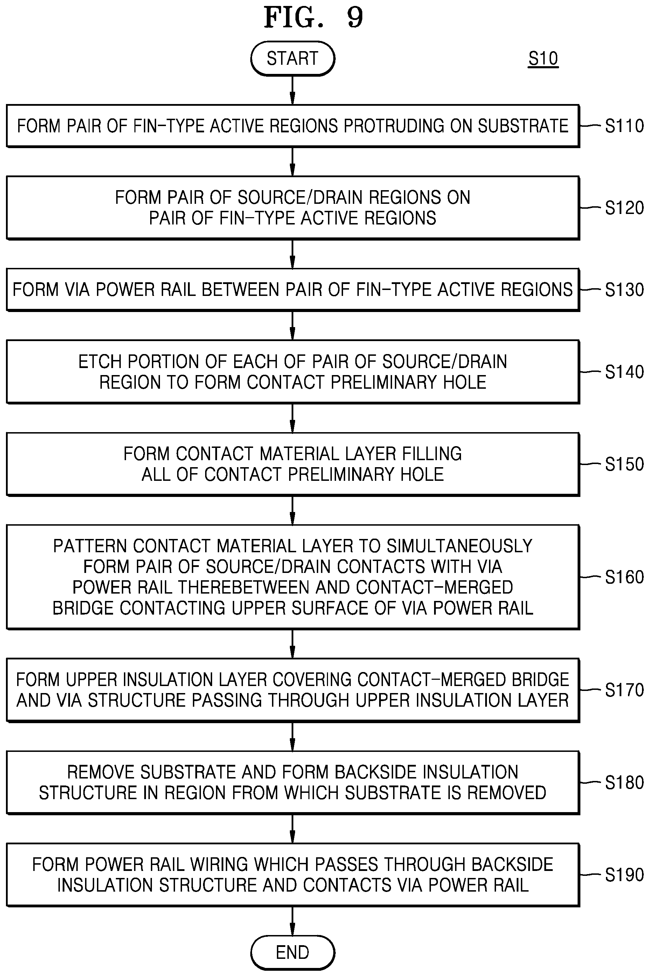

FIG. 9 is a flowchart illustrating a method of manufacturing an integrated circuit device, according to an embodiment.

In a case where some embodiments may be differently implemented, a certain process sequence may be performed unlike or in a different order than a described sequence. For example, two processes continuously or sequentially described may be substantially and simultaneously performed, or may be performed in sequence opposite to a described sequence.

Referring to FIG. 9, a manufacturing method S10 of an integrated circuit device according to an embodiment may include first to ninth operations S110 to S190.

The manufacturing method S10 of an integrated circuit device according to an embodiment may include first operation S110 of forming a pair of fin-type active regions protruding on a substrate, second operation S120 of forming a pair of source/drain regions on the pair of fin-type active regions, third operation S130 of forming a via power rail between the pair of fin-type active regions, fourth operation S140 of etching a portion of each of the pair of source/drain regions to form a contact preliminary hole, fifth operation S150 of forming a contact material layer filling (e.g., all of) the contact preliminary hole, sixth operation S160 of patterning the contact material layer to simultaneously form a pair of source/drain contacts with a via power rail therebetween and a contact-merged bridge contacting an upper surface of the via power rail, seventh operation S170 of forming an upper insulation layer on or covering the contact-merged bridge and a via structure passing through the upper insulation layer, eighth operation S180 of removing the substrate and forming a backside insulation structure in a region from which the substrate is removed, and ninth operation S 190 of forming a power rail wiring which passes through the backside insulation structure and contacts the via power rail.

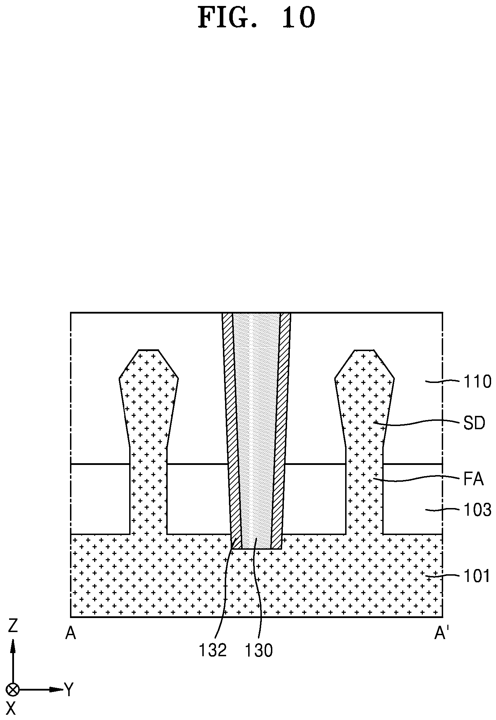

Technical features of and/or structural features resulting from each of the first to ninth operations S110 to S190 will be described in detail with reference to FIGS. 10 to 24 described below.

FIGS. 10 to 24 are diagrams illustrating a method of manufacturing an integrated circuit device in process sequence, according to an embodiment.

Referring to FIG. 10, a nanosheet stack NS (see FIG. 4) and a fin-type active region FA protruding in a vertical direction (a Z direction) from an upper surface of a substrate 101 and extending in a first horizontal direction (an X direction) may be formed by etching a partial region of the substrate 101.

The substrate 101 may be a wafer including silicon (Si). In some embodiments, the substrate 101 may be a wafer including a semiconductor element such as Ge or a compound semiconductor such as silicon carbide (SiC), gallium arsenide (GaAs), indium arsenide (InAs), or indium phosphide (InP). Furthermore, the substrate 101 may have a silicon on insulator (SOI) structure. Also, the substrate 101 may include a conductive region, and for example, may include an impurity-doped well or an impurity-doped structure.

An insulation layer on or covering the fin-type active region FA may be formed on the substrate 101, and then, a device isolation layer 103 may be formed by etching the insulation layer. In this case, the fin-type active region FA may protrude upward from an upper surface of the device isolation layer 103 and may be formed to be exposed. The term "exposed," may be used to describe relationships between elements and/or certain intermediate processes in fabricating a completed semiconductor device, but may not necessarily require exposure of the particular region, layer, structure or other element in the context of the completed device.

A plurality of gate structures 120 (see FIG. 4) including a gate dielectric layer 123 (see FIG. 4), a gate electrode 125 (see FIG. 4), and a gate capping layer 127 may be sequentially formed on the nanosheet stack NS and the fin-type active region FA of the substrate 101 by using a replacement metal gate process. Such processes may be based on conventional technologies, and thus, detailed descriptions thereof are omitted.

A source/drain region SD may be formed by an epitaxial growth process, on the fin-type active region FA exposed at both (e.g., opposing) sides of each of the plurality of gate structures 120.

An interlayer insulation layer 110 may be formed to cover the source/drain region SD and the device isolation layer 103. The interlayer insulation layer 110 may include, for example, an insulating material such as silicon oxide. An upper insulation layer 150 may be formed on an upper surface of the interlayer insulation layer 110 and an upper surface of each of the plurality of gate structures 120.

A via power rail 130 extending in the vertical direction (the Z direction) may be formed between a pair of fin-type active regions FA. The via power rail 130 may pass through the interlayer insulation layer 110 and the device isolation layer 103 in the vertical direction (the Z direction). Also, a rail insulation layer 132 may be formed at both (e.g., opposing) sidewalls of the via power rail 130. The rail insulation layer 132 may include silicon oxide, silicon oxynitride, silicon nitride, or a combination thereof.

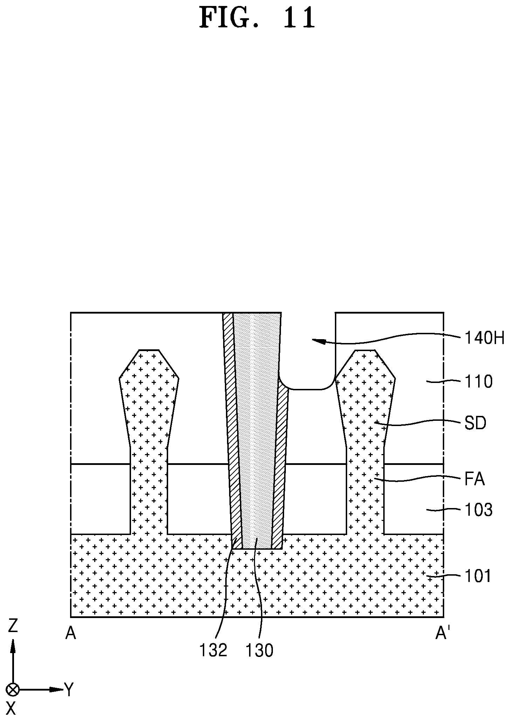

Referring to FIG. 11, a contact isolation hole 140H may be formed between the via power rail 130 and one of a pair of source/drain regions SD.

The contact isolation hole 140H may be formed in the vertical direction (the Z direction) by etching a portion of the rail insulation layer 132 and a portion of the interlayer insulation layer 110, depending on the case. A process of forming the contact isolation hole 140H may be a dry etching process.

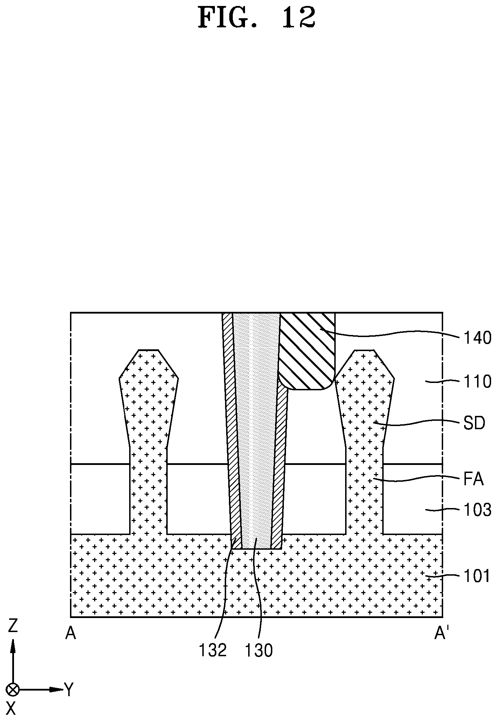

Referring to FIG. 12, a contact isolation insulation layer 140 may be formed by filling an insulating material in a contact isolation hole 140H (see FIG. 11).

To form the contact isolation insulation layer 140, an insulating material layer which fills the contact isolation hole 140H (see FIG. 11) and covers an upper surface of an interlayer insulation layer 110 may be first formed, a surface of the resulting material may be planarized, and a portion of the insulating material layer may be removed so that only a portion, filling the contact isolation hole 140H (see FIG. 11), of the insulating material layer remains, thereby exposing the upper surface of the interlayer insulation layer 110 again.

A chemical mechanical polishing (CMP) process or an etch-back process may be used for the planarization, but the inventive concept is not limited thereto. In some embodiments, the insulating material layer may include silicon nitride, silicon oxynitride, silicon oxycarbide, or a combination thereof. In other embodiments, the insulating material layer may include an air gap or void therein.

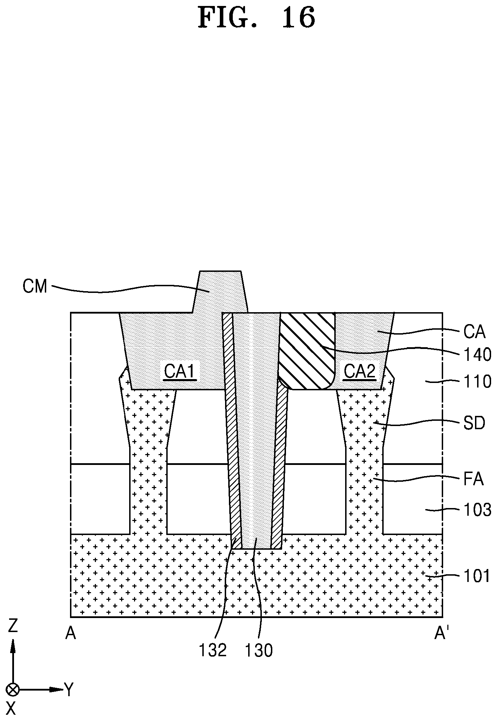

In some embodiments, the contact isolation insulation layer 140 may be formed prior to a source/drain contact CA (see FIG. 16) described below, but is not limited thereto. That is, in other embodiments, the source/drain contact CA (see FIG. 16) may be first formed, and then, a contact isolation insulation layer 140 may be formed.

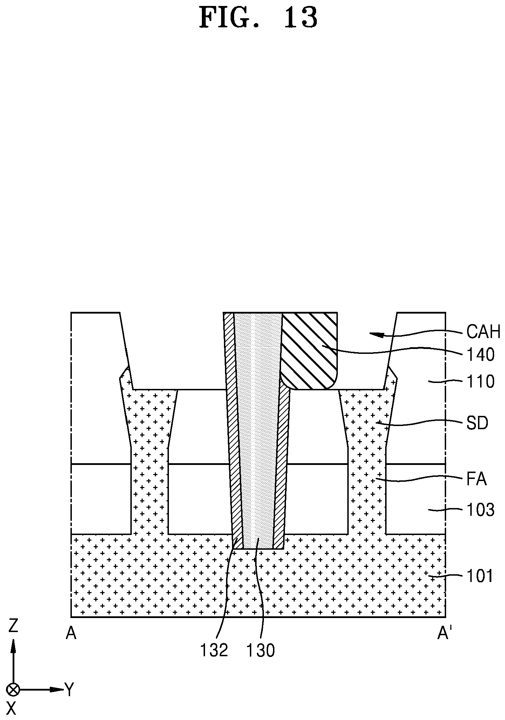

Referring to FIG. 13, by etching a portion of an interlayer insulation layer 110 and a portion of a pair of source/drain regions SD, a contact preliminary hole CAH exposing the pair of source/drain regions SD may be formed between two adjacent gate structures 120 of a plurality of gate structures 120.

At least a portion of the pair of source/drain regions SD exposed through the contact preliminary hole CAH may be consumed or otherwise removed in performing an etching process of forming the contact preliminary hole CAH. A lowest surface of an inner surface of the contact preliminary hole CAH may be disposed between the pair of source/drain regions SD exposed at the inner surface of the contact preliminary hole CAH.

In a process of forming the contact preliminary hole CAH, a contact isolation insulation layer 140 may not be etched and may remain. That is, an etching process of forming the contact preliminary hole CAH may be a process where an etch selectivity of or corresponding to the interlayer insulation layer 110 differs from an etch selectivity of or corresponding to the contact isolation insulation layer 140.

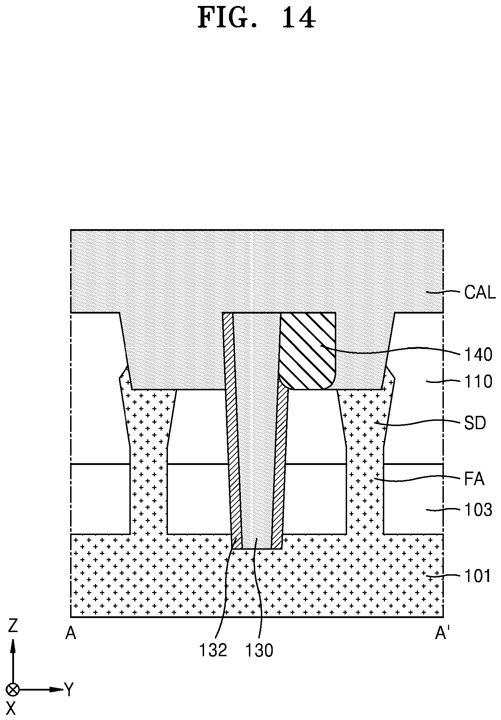

Referring to FIG. 14, a contact preliminary hole CAH (see FIG. 13) may be fully filled, and a contact material layer CAL may be formed to cover an upper surface of the interlayer insulation layer 110.

The contact material layer CAL may be formed to contact a pair of source/drain regions SD. The contact material layer CAL may pass through the interlayer insulation layer 110 in a vertical direction (a Z direction) and may contact the source/drain region SD.

The contact material layer CAL may include, for example, Mo, Cu, W, Co, Ru, Mn, Ti, Ta, Al, a combination thereof, or an alloy thereof, but is not limited thereto.

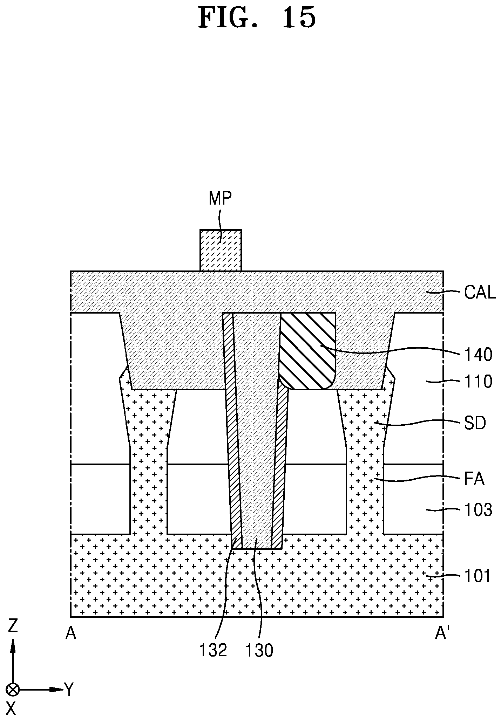

Referring to FIG. 15, a portion of an upper portion of a contact material layer CAL may be removed by performing a polishing process on an upper surface of the contact material layer CAL.

The polishing process may be performed as a CMP process or an etch-back process. Due to the polishing process, a height of the upper surface of the contact material layer CAL may be lowered, and thus a thickness may be reduced. In some embodiments, the polishing process on the contact material layer CAL may be performed so that an upper surface of an interlayer insulation layer 110 is exposed.

A mask pattern MP may be formed on the contact material layer CAL. The mask pattern MP may be formed through an argon fluoride (ArF) lithography process or an extreme ultraviolet (EUV) lithography process. In some embodiments, the mask pattern MP may be a photoresist pattern or a hard mask pattern, but is not limited thereto.

Referring to FIG. 16, a contact material layer CAL (see FIG. 15) may be etched by using a mask pattern MP (see FIG. 15) as an etch mask, and thus, a pair of source/drain contacts CA may be formed on a pair of source/drain regions SD.

A contact-merged bridge CM may be disposed on a first source/drain contact CA1 of the pair of source/drain contacts CA and a via power rail 130. Based on such a manufacturing process, the first source/drain contact CA1 and the contact-merged bridge CM may be configured as a one-body or unitary structure where a boundary surface or interface is not formed therebetween. Also, a contact isolation insulation layer 140 may be disposed between a second source/drain contact CA2 of the pair of source/drain contacts CA and the via power rail 130.

In other words, the pair of source/ drain contacts CA may be formed by a damascene process, and simultaneously, the contact-merged bridge CM may be formed by an anisotropic etching process. The anisotropic etching process may be, for example, a plasma etching process. Accordingly, an angle between a bottom surface and a sidewall of the contact-merged bridge CM may be an acute angle, and an angle between a bottom surface and an outer sidewall of each of the pair of source/drain contacts CA may be an obtuse angle.

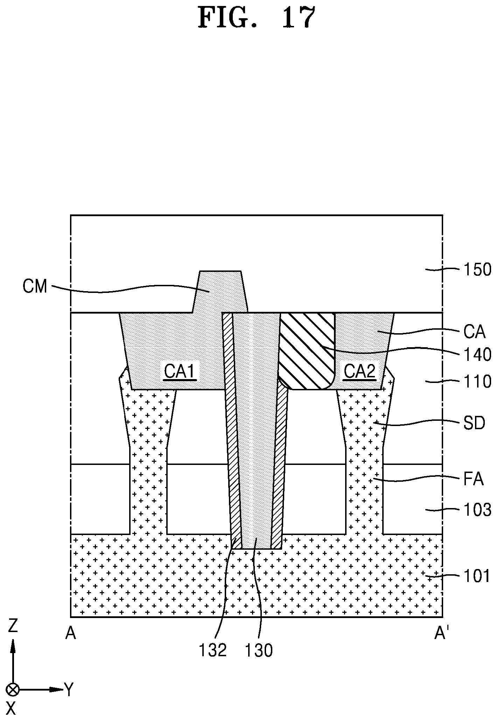

Referring to FIG. 17, an upper insulation layer 150 may be formed to cover both (e.g., opposing) sidewalls of a contact-merged bridge CM and an upper surface of each of a via power rail 130, a rail insulation layer 132, a contact isolation insulation layer 140, a pair of source/drain contacts CA, a contact-merged bridge CM, and an interlayer insulation layer 110.

The upper insulation layer 150 may include, for example, silicon oxide, silicon nitride, an ultra low-k (ULK) material having an ultra low-k dielectric constant, or a combination thereof.

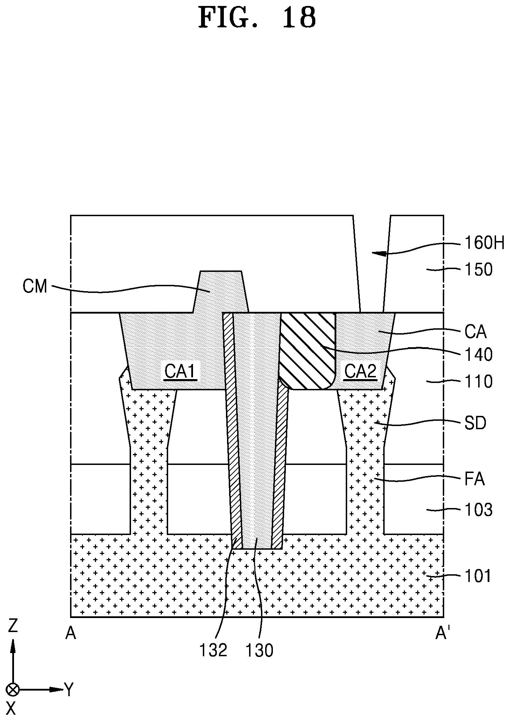

Referring to FIG. 18, a via preliminary hole 160H exposing a portion of an upper surface of a second source/drain contact CA2 may be formed to pass through the upper insulation layer 150.

The via preliminary hole 160H may be formed in a vertical direction (a Z direction) by etching a portion of the upper insulation layer 150. A process of forming the via preliminary hole 160H may be a dry etching process.

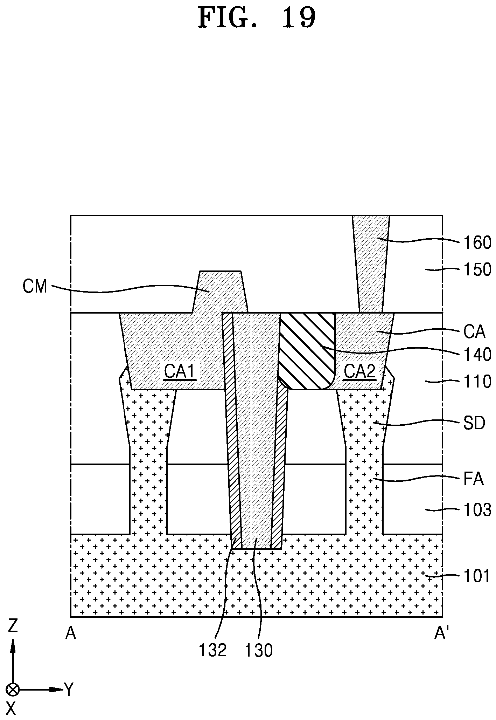

Referring to FIG. 19, a via structure 160 may be formed by filling a conductive material in the via preliminary hole 160H (see FIG. 19).

To form the via structure 160, a conductive material layer which fills the via preliminary hole 160H (see FIG. 19) and covers an upper surface of an upper insulation layer 150 may be first formed, a surface of the resulting material may be planarized, and a portion of the conductive material layer may be removed so that only a portion, filling the via preliminary hole 160H (see FIG. 19), of the conductive material layer remains, thereby exposing the upper surface of the upper insulation layer 150 again.

A CMP process or an etch-back process may be used for the planarization, but the inventive concept is not limited thereto. In some embodiments, the conductive material layer may include, for example, Mo, Cu, W, Co, Ru, Mn, Ti, Ta, Al, a combination thereof, or an alloy thereof, but is not limited thereto.

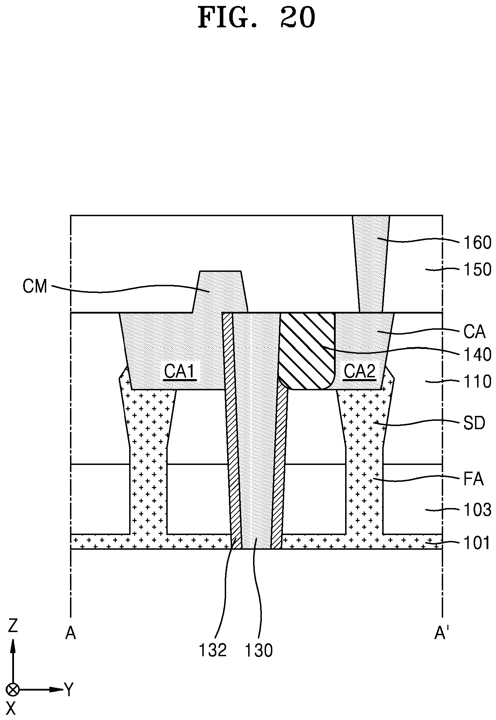

Referring to FIG. 20, a backside removal process of removing a portion of a substrate 101 may be performed.

The backside removal process for decreasing a thickness of the substrate 101 may include a process of alternately performing a grinding process and a wet etching process to expose a bottom surface of a via power rail 130 and a bottom surface of a rail insulation layer 132. Accordingly, after a portion of the substrate 101 is removed, a backside surface of the substrate 101 may be closer to the device isolation layer 103.

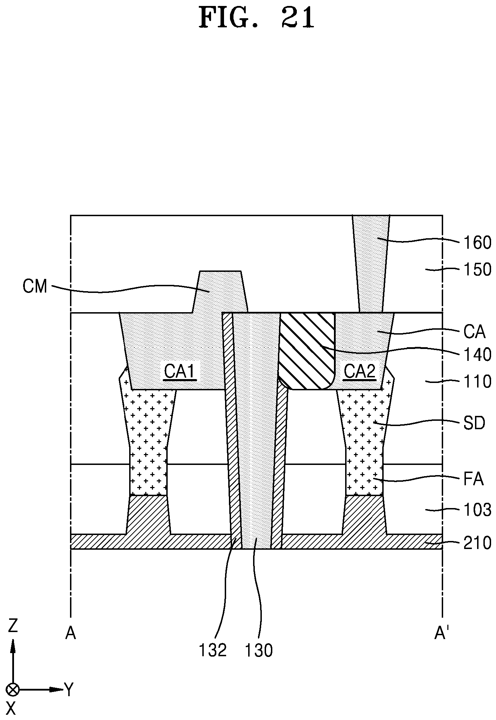

Referring to FIG. 21, a lower portion of each of a pair of fin-type active regions FA and all of a substrate 101 (see FIG. 20) may be removed, and an upper backside insulation structure 210 including a protrusion portion may be formed in a region formed through the removal.

As described above, a bulk-less structure may be obtained by removing all of the substrate 101 (see FIG. 20). The upper backside insulation structure 210 may include, for example, a material selected from among silicon oxide, silicon nitride, silicon carbide, and a low-k dielectric material.

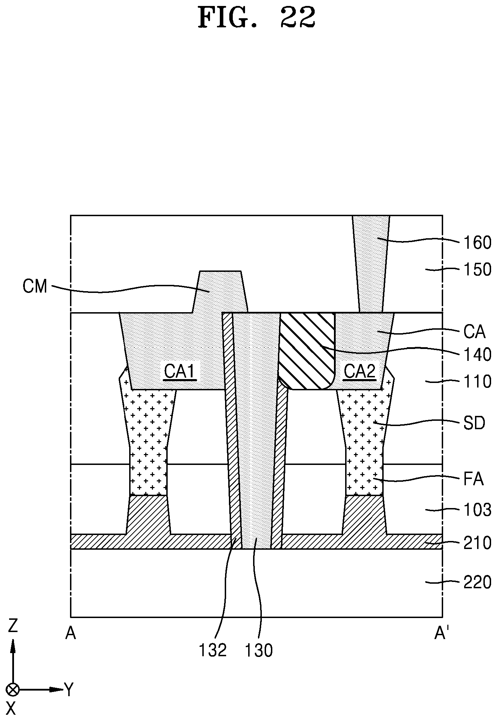

Referring to FIG. 22, a lower backside insulation structure 220 may be formed on a lower surface of an upper backside insulation structure 210.

The lower backside insulation structure 220 may include, for example, a material selected from among silicon oxide, silicon nitride, silicon carbide, and a low-k dielectric material. In some embodiments, the upper backside insulation structure 210 and the lower backside insulation structure 220 may include different insulating materials.

The upper backside insulation structure 210 and the lower backside insulation structure 220 may be referred to as backside insulation structures 210 and 220. Therefore, the backside insulation structures 210 and 220 may be disposed under a pair of fin-type active regions FA.

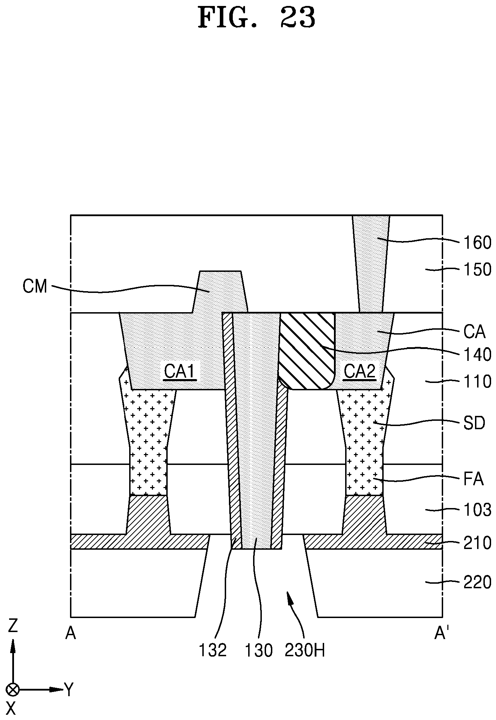

Referring to FIG. 23, power rail preliminary holes 230H passing through backside insulation structures 210 and 220 in a vertical direction (a Z direction) may be formed.

Forming power rail preliminary holes 230H may include a process of etching a portion of each of the backside insulation structures 210 and 220 from a backside surface of each of the backside insulation structures 210 and 220 to expose a bottom surface of a via power rail 130 and a bottom surface and a lower sidewall of a rail insulation layer 132.

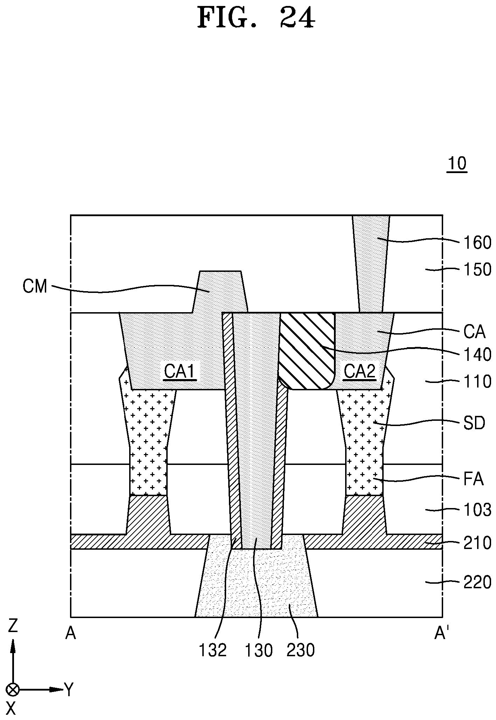

Referring to FIG. 24, a power rail wiring 230 may be formed by filling a conductive material in a power rail preliminary hole 230H (see FIG. 23).

To form the power rail wiring 230, a conductive material layer which fills the power rail preliminary hole 230H (see FIG. 23) and covers a bottom surface of a lower backside insulation structure 220 may be first formed, a surface of the resulting material may be planarized, and a portion of the conductive material layer may be removed so that only a portion, filling the power rail preliminary hole 230H (see FIG. 23), of the conductive material layer remains, thereby exposing the bottom surface of the lower backside insulation structure 220 again.

Subsequently, depending on the case, a backside wiring structure (not shown) may be formed under the power rail wiring 230 and the lower backside insulation structure 220, thereby manufacturing the integrated circuit device 10 according to an embodiment.

As described above, a method of manufacturing the integrated circuit device 10 has been described above with reference to FIGS. 10 to 24, but it will be understood s that the integrated circuit devices 20 and 30 described above with reference to FIGS. 7 and 8 may be manufactured by implementing various changes or modifications from the above description within the scope of the inventive concept.

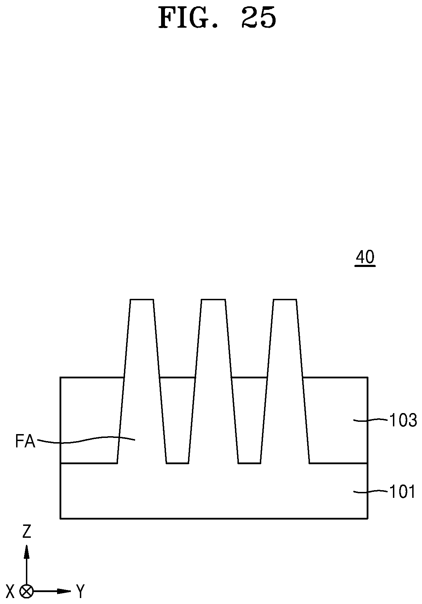

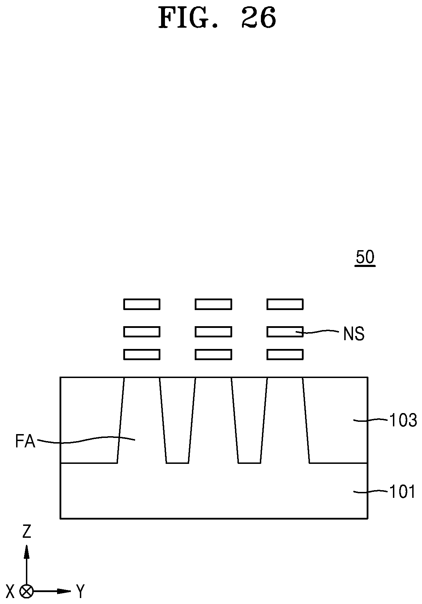

FIGS. 25 and 26 are cross-sectional views corresponding to an active pattern of an integrated circuit device, according to an embodiment.

Most elements configuring integrated circuit devices 40 and 50 described below and materials of the elements may be substantially the same as or similar to the descriptions of FIGS. 2 to 6. Therefore, for convenience of description, differences with the integrated circuit device 10 described above will be mainly described below.

Referring to FIG. 25, in an integrated circuit device 40, in a case where a fin-type active region FA having a fin shape extends in a first horizontal direction (an X direction), a transistor configured with the fin-type active region FA and a gate electrode 125 may be referred to as a fin-type field effect transistor (FinFET).

Referring to FIG. 26, in an integrated circuit device 50, a fin-type active region FA may include a plurality of nanosheet stacks NS which are spaced apart from one another in a vertical direction (a Z direction) and extend in a first horizontal direction (an X direction), and a transistor configured with the plurality of nanosheet stacks NS and a gate electrode 125 may include a multi-bridge channel FET (NMCFET).

Although not shown, a nanosheet for a p-type transistor and a nanosheet for an n-type transistor may be separated from each other by a dielectric wall, and thus, the integrated circuit device 50 may include a ForkFET having a structure where the n-type transistor is closer to the p-type transistor.

Also, the integrated circuit device 50 may include a vertical FET (VFET) having a structure where source/drain regions are spaced apart from each other in a vertical direction (a Z direction) with a channel region therebetween and a gate electrode surrounds the channel region.

Also, the integrated circuit device 50 may include a complementary FET (CFET), a negative FET (NCFET), and a carbon nanotube FET (CNT), or may include a bipolar junction transistor and the other three-dimensional (3D) transistor.

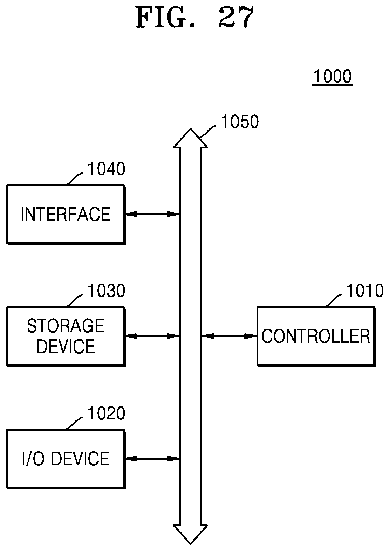

FIG. 27 is a block diagram illustrating a system 1000 including an integrated circuit device, according to an embodiment.

Referring to FIG. 27, the system 1000 may include a controller 1010, an input/output (I/O) device 1020, a storage device 1030, an interface 1040, and a bus 1050.

The system 1000 may be a mobile system, or may be a system which transmits or receives information. In some embodiments, the mobile system may be a portable computer, a web tablet computer, a mobile phone, a digital music player, or a memory card.

The controller 1010 may be configured for controlling an execution program in the system 1000 and may be configured with a microprocessor, a digital signal processor, a microcontroller, or a device similar thereto.

The I/O device 1020 may be used to input or output data of the system 1000. The system 1000 may be connected with an external device (for example, a personal computer or a network) by using the I/O device 1020 and may exchange data with the external device. The I/O device 1020 may be, for example, a touch screen, a touch pad, a keyboard, or a display.

The storage device 1030 may store data for an operation of the controller 1010, or may store data obtained through processing by the controller 1010. The storage device 1030 may include one of the integrated circuit devices 10, 20, 30, 40, and 50 according to an embodiment described above.

The interface 1040 may be a data transmission path between the system 1000 and an external device. The controller 1010, the I/O device 1020, the storage device 1030, and the interface 1040 may communicate with one another through the bus 1050.

Hereinabove, embodiments have been described in the drawings and the specification. Embodiments have been described by using the terms described herein, but this has been merely used for describing the inventive concept and has not been used for limiting a meaning or limiting the scope of the inventive concept defined in the following claims. Accordingly, the scope of the inventive concept may be defined based on the scope of the following claims.

While the inventive concept has been particularly shown and described with reference to embodiments thereof, it will be understood that various changes in form and details may be made therein without departing from the scope of the following claims.

## Claims

1. An integrated circuit device (10) comprising:
a pair of fin-type active regions (FA) spaced apart from each other in a second horizontal direction intersecting a first horizontal direction, wherein the pair of fin-type active regions (FA) protrude in a vertical direction that is perpendicular to the first horizontal direction from a backside insulation structure (210, 220) and extend longitudinally in the first horizontal direction;
a device isolation layer (103) on opposing sidewalls of each of the pair of fin-type active regions (FA);
a pair of source/drain regions (SD) on the pair of fin-type active regions (FA);
an interlayer insulation layer (110) on the pair of source/drain regions (SD) and the device isolation layer (103);
a via power rail (130) extending longitudinally in the first horizontal direction between the pair of fin-type active regions (FA) and extending through the interlayer insulation layer (110) and the device isolation layer (103) in the vertical direction;
a pair of source/drain contacts (CA) arranged in the second horizontal direction with the via power rail (130) therebetween to contact the pair of source/drain regions (SD);
a contact-merged bridge (CM) on and electrically connected to the via power rail (130) and a first source/drain contact (CA1) of the pair of source/drain contacts (CA);
a contact isolation insulation layer (140) on the via power rail (130) and a second source/drain contact (CA2) of the pair of source/drain contacts (CA);
a via structure (160) on the second source/drain contact (CA2); and
a power rail wiring (230) extending through the backside insulation structure (210, 220) in the vertical direction and contacting the via power rail (130),
wherein the first source/drain contact (CA1) and the contact-merged bridge (CM) have a unitary structure that is free of a boundary surface therebetween,
wherein a thickness of the contact bridge (CM) in the vertical direction is less than a thickness of the via structure (160) in the vertical direction, and
wherein an angle (D2) between a bottom surface and a sidewall of the contact-merged bridge (CM) is acute, and the bottom surface of the contact-merged bridge (CM) is on an upper surface of the via power rail (130),
wherein an angle (D3) between a bottom surface and a sidewall of the via structure (160) is obtuse, and the bottom surface of the via structure (160) is on an upper surface of the second source/drain contact (CA2), and/or
wherein an angle (D1) between a bottom surface and an outer sidewall of each of the pair of source/drain contacts (CA) is obtuse, and the bottom surface of each of the pair of source/drain contacts (CA) is on a respective upper surface of the pair of source/drain regions (SD).

2. The integrated circuit device (10) of claim 1, further comprising:
a rail insulation layer (132) on opposing sidewalls of the via power rail (130),
wherein an inner sidewall of the first source/drain contact (CA1), which faces the second source/drain contact (CA2), contacts the rail insulation layer (132).

3. The integrated circuit device (10) of claim 2, wherein the upper surface of the via power rail (130), an upper surface of the rail insulation layer (132), and the upper surface of the second source/drain contact (CA2) are coplanar.

4. The integrated circuit device (10) of claim 2 or 3, wherein, in a cross-sectional view, the contact-merged bridge (CM) has a trapezoid shape, and
the bottom surface of the contact-merged bridge (CM) contacts the upper surface of the via power rail (130) and the upper surface of the rail insulation layer (132).

5. The integrated circuit device (10) of any preceding claim, wherein a portion of a sidewall of the via power rail (130) contacts the contact isolation insulation layer (140), and
wherein an inner sidewall of the second source/drain contact (CA2), which faces the first source/drain contact (CA1), contacts the contact isolation insulation layer (140).

6. The integrated circuit device (10) of claim 5, wherein the contact isolation insulation layer (140) and the contact-merged bridge (CM) are spaced apart from each other in the second horizontal direction.

7. The integrated circuit device (10) of any preceding claim, wherein the first source/drain contact (CA1) and the via power rail (130) do not directly contact each other at respective sidewalls and are electrically connected to each other by the contact-merged bridge (CM) at an upper surface of the via power rail (130).

8. The integrated circuit device (10) of any preceding claim, further comprising:
a gate electrode (125) extending longitudinally in the second horizontal direction on the pair of fin-type active regions (FA); and
a gate capping layer (127) on the gate electrode (125),
wherein a bottom surface of the contact-merged bridge (CM) is spaced apart from an upper surface of the gate electrode (125) in the vertical direction.

9. The integrated circuit device (10) of claim 8, further comprising a pair of nanosheet stacks (NS) between the pair of fin-type active regions (FA) and the gate electrode (125),
wherein, in a plan view, the contact-merged bridge (CM) does not overlap the pair of nanosheet stacks (NS).

10. An integrated circuit device (20) comprising:
an upper backside insulation structure (210) including a protrusion portion and a lower backside insulation structure (220) on a lower surface of the upper backside insulation structure (210) opposite the protrusion portion;
a pair of fin-type active regions (FA) on the protrusion portion of the upper backside insulation structure (210) and extending longitudinally in a first horizontal direction;
a device isolation layer (103) on opposing sidewalls of each of the pair of fin-type active regions (FA);
a pair of nanosheet stacks (NS) on first portions of the pair of fin-type active regions (FA);
a gate electrode (125) extending longitudinally on the pair of fin-type active regions (FA) to intersect with the pair of fin-type active regions (FA) and extending on the pair of nanosheet stacks (NS);
a pair of source/drain regions (SD) on second portions of the pair of fin-type active regions (FA);
an interlayer insulation layer (110) on the pair of source/drain regions (SD) and the device isolation layer (103);
a via power rail (130) extending longitudinally in the first horizontal direction between the pair of fin-type active regions (FA) and extending through the interlayer insulation layer (110) and the device isolation layer (103) in a vertical direction that is perpendicular to the first horizontal direction;
a pair of source/drain contacts (CA) spaced apart from each other with the via power rail (130) therebetween to contact the pair of source/drain regions (SD);
a contact bridge (CM2) on the via power rail (130) and a first source/drain contact (CA1) of the pair of source/drain contacts (CA);
a via structure (160) on a second source/drain contact (CA2) of the pair of source/drain contacts (CA); and
a power rail wiring (230) extending through the upper backside insulation structure (210) and the lower backside insulation structure (220) in the vertical direction and contacting the via power rail (130),
wherein an angle (D2) between a bottom surface and a sidewall of the contact bridge (CM2) is acute, the bottom surface of the contact bridge (CM2) being on an upper surface of the via power rail (130), and wherein an angle (D3) between a bottom surface and a sidewall of the via structure (160) is obtuse, the bottom surface of the via structure (160) being on an upper surface of the second source/drain contact (CA2), and
wherein a thickness (CM2T) of the contact bridge (CM2) in the vertical direction is substantially equal to a thickness (160T) of the via structure (160) in the vertical direction.

11. The integrated circuit device (20) of claim 10, wherein the first source/drain contact (CA1) and the contact bridge (CM2) have a unitary structure that is free of a boundary surface therebetween.

## Patentansprüche

1. Integrierte Schaltungsvorrichtung (10), umfassend:
ein Paar von rippenartigen aktiven Bereichen (FA), die in einer zweiten horizontalen Richtung, die eine erste horizontale Richtung schneidet, voneinander beabstandet sind, wobei das Paar von rippenartigen aktiven Bereichen (FA) in einer vertikalen Richtung, die senkrecht zu der ersten horizontalen Richtung ist, von einer Rückseitenisolierstruktur (210, 220) vorsteht und sich in der ersten horizontalen Richtung in Längsrichtung erstreckt;
eine Vorrichtungsisolationsschicht (103) auf gegenüberliegenden Seitenwänden jedes des Paares von rippenartigen aktiven Bereichen (FA);
ein Paar von Source/Drain-Bereichen (SD) auf dem Paar von rippenartigen aktiven Bereichen (FA);
eine Zwischenschichtisolierschicht (110) auf dem Paar von Source/Drain-Bereichen (SD) und der Vorrichtungsisolationsschicht (103);
eine Durchgangsleistungsschiene (130), die sich in Längsrichtung in der ersten horizontalen Richtung zwischen dem Paar von rippenartigen aktiven Bereichen (FA) erstreckt und sich durch die Zwischenschichtisolierschicht (110) und die Vorrichtungsisolationsschicht (103) in der vertikalen Richtung erstreckt;
ein Paar von Source/Drain-Kontakten (CA), die in der zweiten horizontalen Richtung mit der Durchgangsleistungsschiene (130) dazwischen angeordnet sind, um das Paar von Source/Drain-Bereichen (SD) zu kontaktieren;
eine kontaktverschmolzene Brücke (CM), die mit der Durchgangsleistungsschiene (130) und einem ersten Source/Drain-Kontakt (CA1) des Paares von Source/Drain-Kontakten (CA) elektrisch verbunden ist;
eine Kontaktisolationsisolierschicht (140) auf der Durchgangsleistungsschiene (130) und einem zweiten Source/Drain-Kontakt (CA2) des Paares von Source/Drain-Kontakten (CA);
eine Durchgangsstruktur (160) auf dem zweiten Source/Drain-Kontakt (CA2); und
eine Leistungsschienenverdrahtung (230), die sich durch die Rückseitenisolierstruktur (210, 220) in der vertikalen Richtung erstreckt und die Durchgangsleistungsschiene (130) kontaktiert,
wobei der erste Source/Drain-Kontakt (CA1) und die kontaktverschmolzene Brücke (CM) eine einheitliche Struktur aufweisen, die frei von einer dazwischen liegenden Grenzfläche ist,
wobei eine Dicke der Kontaktbrücke (CM) in der vertikalen Richtung geringer ist als eine Dicke der Durchgangsstruktur (160) in der vertikalen Richtung, und
wobei ein Winkel (D2) zwischen einer unteren Fläche und einer Seitenwand der kontaktverschmolzenen Brücke (CM) spitz ist, und die untere Fläche der kontaktverschmolzenen Brücke (CM) auf einer oberen Fläche der Durchgangsleistungsschiene (130) liegt,
wobei ein Winkel (D3) zwischen einer unteren Fläche und einer Seitenwand der Durchgangsstruktur (160) stumpf ist und die untere Fläche der Durchgangsstruktur (160) auf einer oberen Fläche des zweiten Source/Drain-Kontakts (CA2) liegt, und/oder
wobei ein Winkel (D1) zwischen einer unteren Fläche und einer äußeren Seitenwand jedes des Paares von Source/Drain-Kontakten (CA) stumpf ist und die untere Fläche jedes des Paares von Source/Drain-Kontakten (CA) auf einer jeweiligen oberen Fläche des Paares von Source/Drain-Bereichen (SD) liegt.

2. Integrierte Schaltungsvorrichtung (10) nach Anspruch 1, weiter umfassend:
eine Schienenisolierschicht (132) an gegenüberliegenden Seitenwänden der Durchgangsleistungsschiene (130),
wobei eine innere Seitenwand des ersten Source/Drain-Kontakts (CA1), die dem zweiten Source/Drain-Kontakt (CA2) zugewandt ist, die Schienenisolierschicht (132) kontaktiert.

3. Integrierte Schaltungsvorrichtung (10) nach Anspruch 2, wobei die obere Fläche der Durchgangsleistungsschiene (130), eine obere Fläche der Schienenisolierschicht (132) und die obere Fläche des zweiten Source/Drain-Kontakts (CA2) koplanar sind.

4. Integrierte Schaltungsvorrichtung (10) nach Anspruch 2 oder 3, wobei in einer Querschnittsansicht die kontaktverschmolzene Brücke (CM) eine Trapezform aufweist, und
die untere Fläche der kontaktverschmolzenen Brücke (CM) die obere Fläche der Durchgangsleistungsschiene (130) und die obere Fläche der Schienenisolierschicht (132) kontaktiert.

5. Integrierte Schaltungsvorrichtung (10) nach einem vorstehenden Anspruch, wobei ein Abschnitt einer Seitenwand der Durchgangsleistungsschiene (130) die Kontaktisolationsisolierschicht (140) kontaktiert, und
wobei eine innere Seitenwand des zweiten Source/Drain-Kontakts (CA2), die dem ersten Source/Drain-Kontakt (CA1) zugewandt ist, die Kontaktisolationsisolierschicht (140) kontaktiert.

6. Integrierte Schaltungsvorrichtung (10) nach Anspruch 5, wobei die Kontaktisolationsisolierschicht (140) und die kontaktverschmolzene Brücke (CM) in der zweiten horizontalen Richtung voneinander beabstandet sind.

7. Integrierte Schaltungsvorrichtung (10) nach einem vorstehenden Anspruch, wobei der erste Source/Drain-Kontakt (CA1) und die Durchgangsleistungsschiene (130) einander an den jeweiligen Seitenwänden nicht direkt kontaktieren und durch die kontaktverschmolzene Brücke (CM) an einer oberen Fläche der Durchgangsleistungsschiene (130) elektrisch miteinander verbunden sind.

8. Integrierte Schaltungsvorrichtung (10) nach einem vorstehenden Anspruch, weiter umfassend:
eine Gate-Elektrode (125), die sich in Längsrichtung in der zweiten horizontalen Richtung auf dem Paar von rippenartigen aktiven Bereichen (FA) erstreckt; und
eine Gate-Deckschicht (127) auf der Gate-Elektrode (125),
wobei eine untere Fläche der kontaktverschmolzenen Brücke (CM) von einer oberen Fläche der Gate-Elektrode (125) in der vertikalen Richtung beabstandet ist.

9. Integrierte Schaltungsvorrichtung (10) nach Anspruch 8, weiter umfassend ein Paar von Nanoblattstapeln (NS) zwischen dem Paar von rippenartigen aktiven Bereichen (FA) und der Gate-Elektrode (125),
wobei in einer Draufsicht die kontaktverschmolzene Brücke (CM) das Paar von Nanoblattstapeln (NS) nicht überlappt.

10. Integrierte Schaltungsvorrichtung (20), umfassend:
eine obere Rückseitenisolierstruktur (210), die einen Vorsprungsabschnitt und eine untere Rückseitenisolierstruktur (220) auf einer unteren Fläche der oberen Rückseitenisolierstruktur (210) gegenüber dem Vorsprungsabschnitt beinhaltet;
ein Paar von rippenartigen aktiven Bereichen (FA) auf dem Vorsprungsabschnitt der oberen Rückseitenisolierstruktur (210) und sich in Längsrichtung in einer ersten horizontalen Richtung erstreckend;
eine Vorrichtungsisolationsschicht (103) auf gegenüberliegenden Seitenwänden jedes des Paares von rippenartigen aktiven Bereichen (FA);
ein Paar von Nanoblattstapeln (NS) auf ersten Abschnitten des Paares von rippenartigen aktiven Bereichen (FA);
eine Gate-Elektrode (125), die sich in Längsrichtung auf dem Paar von rippenartigen aktiven Bereichen (FA) erstreckt, um sich mit dem Paar von rippenartigen aktiven Bereichen (FA) zu überschneiden, und die sich auf dem Paar von Nanoblattstapeln (NS) erstreckt;
ein Paar von Source/Drain-Bereichen (SD) auf zweiten Abschnitten des Paares von rippenartigen aktiven Bereichen (FA);
eine Zwischenschichtisolierschicht (110) auf dem Paar von Source/Drain-Bereichen (SD) und der Vorrichtungsisolationsschicht (103);
eine Durchgangsleistungsschiene (130), die sich in Längsrichtung in der ersten horizontalen Richtung zwischen dem Paar von rippenartigen aktiven Bereichen (FA) erstreckt und sich durch die Zwischenschichtisolierschicht (110) und die Vorrichtungsisolationsschicht (103) in einer vertikalen Richtung erstreckt, die senkrecht zu der ersten horizontalen Richtung ist;
ein Paar von Source/Drain-Kontakten (CA), die voneinander beabstandet sind, wobei sich die Durchgangsleistungsschiene (130) dazwischen befindet, um das Paar von Source/Drain-Bereichen (SD) zu kontaktieren;
eine Kontaktbrücke (CM2) auf der Durchgangsleistungsschiene (130) und einen ersten Source/Drain-Kontakt (CA1) des Paars von Source/Drain-Kontakten (CA);
eine Durchgangsstruktur (160) auf einem zweiten Source/Drain-Kontakt (CA2) des Paares von Source/Drain-Kontakten (CA); und
eine Leistungsschienenverdrahtung (230), die sich durch die obere Rückseitenisolierstruktur (210) und die untere Rückseitenisolierstruktur (220) in der vertikalen Richtung erstreckt und die Durchgangsleistungsschiene (130) kontaktiert,
wobei ein Winkel (D2) zwischen einer unteren Fläche und einer Seitenwand der Kontaktbrücke (CM2) spitz ist, wobei die untere Fläche der Kontaktbrücke (CM2) auf einer oberen Fläche der Durchgangsleistungsschiene (130) liegt, und wobei ein Winkel (D3) zwischen einer unteren Fläche und einer Seitenwand der Durchgangsstruktur (160) stumpf ist, wobei die untere Fläche der Durchgangsstruktur (160) auf einer oberen Fläche des zweiten Source/Drain-Kontakts (CA2) liegt, und
wobei eine Dicke (CM2T) der Kontaktbrücke (CM2) in der vertikalen Richtung im Wesentlichen gleich einer Dicke (160T) der Durchgangsstruktur (160) in der vertikalen Richtung ist.

11. Integrierte Schaltungsvorrichtung (20) nach Anspruch 10, wobei der erste Source/Drain-Kontakt (CA1) und die Kontaktbrücke (CM2) eine einheitliche Struktur aufweisen, die frei von einer dazwischen liegenden Grenzfläche ist.

## Revendications

1. Dispositif de circuit intégré (10) comprenant :
une paire de régions actives de type ailette (FA) espacées l'une de l'autre dans une seconde direction horizontale coupant une première direction horizontale, dans lequel la paire de régions actives de type ailette (FA) fait saillie dans une direction verticale qui est perpendiculaire à la première direction horizontale à partir d'une structure d'isolation arrière (210, 220) et s'étend longitudinalement dans la première direction horizontale ;
une couche d'isolation de dispositif (103) sur des parois latérales opposées de chacune de la paire de régions actives de type ailette (FA) ;
une paire de régions source/drain (SD) sur la paire de régions actives de type ailette (FA) ;
une couche d'isolation intermédiaire (110) sur la paire de régions source/drain (SD) et la couche d'isolation du dispositif (103) ;
un rail d'alimentation via (130) s'étendant longitudinalement dans la première direction horizontale entre la paire de régions actives de type ailette (FA) et s'étendant à travers la couche d'isolation intermédiaire (110) et la couche d'isolation du dispositif (103) dans la direction verticale ;
une paire de contacts source/drain (CA) agencés dans la seconde direction horizontale avec le rail d'alimentation via (130) entre eux pour établir le contact avec la paire de régions source/drain (SD) ;
un pont fusionné de contact (CM) sur et connecté électriquement au rail d'alimentation via (130) et un premier contact source/drain (CA1) de la paire de contact source/drain (CA) ;
une couche isolante d'isolation de contact (140) sur le rail d'alimentation via (130) et un second contact source/drain (CA2) de la paire de contacts source/drain (CA) ;
une structure via (160) sur le second contact source/drain (CA2) ; et
un câblage de rail d'alimentation (230) s'étendant à travers la structure d'isolation arrière (210, 220) dans la direction verticale et entrant en contact avec le rail d'alimentation via (130),
dans lequel le premier contact source/drain (CA1) et le pont fusionné de contact (CM) présentent une structure unitaire qui est dépourvue de surface limite entre eux,
dans lequel une épaisseur du pont de contact (CM) dans la direction verticale est inférieure à une épaisseur de la structure via (160) dans la direction verticale, et
dans lequel un angle (D2) entre une surface inférieure et une paroi latérale du pont fusionné de contact (CM) est aigu, et la surface inférieure du pont fusionné de contact (CM) se trouve sur une surface supérieure du rail d'alimentation via (130),
dans lequel un angle (D3) entre une surface inférieure et une paroi latérale de la structure via (160) est obtus, et la surface inférieure de la structure via (160) repose sur une surface supérieure du second contact source/drain (CA2), et/ou
dans lequel un angle (D1) entre une surface inférieure et une paroi latérale extérieure de chacun des deux contacts source/drain (CA) est obtus, et la surface inférieure de chaque paire de contacts source/drain (CA) se trouve sur une surface supérieure respective de la paire de régions source/drain (SD).

2. Dispositif de circuit intégré (10) selon la revendication 1, comprenant en outre :
une couche d'isolation de rail (132) sur des parois latérales opposées du rail d'alimentation via (130),
dans lequel une paroi latérale intérieure du premier contact source/drain (CA1), qui fait face au second contact source/drain (CA2), entre en contact avec la couche d'isolation du rail (132).

3. Dispositif de circuit intégré (10) selon la revendication 2, dans lequel la surface supérieure du rail d'alimentation via (130), une surface supérieure de la couche d'isolation du rail (132) et la surface supérieure du second contact source/drain (CA2) sont coplanaires.

4. Dispositif de circuit intégré (10) selon la revendication 2 ou 3, dans lequel, en une vue transversale, le pont fusionné de contact (CM) présente une forme trapézoïdale, et
la surface inférieure du pont fusionné de contact (CM) entre en contact avec la surface supérieure du rail d'alimentation via (130) et la surface supérieure de la couche d'isolation du rail (132).

5. Dispositif de circuit intégré (10) de toute revendication précédente, dans lequel une partie d'une paroi latérale du rail d'alimentation via (130) entre en contact avec la couche isolante d'isolation de contact (140), et
dans lequel une paroi latérale intérieure du second contact source/drain (CA2), qui fait face au premier contact source/drain (CA1), entre en contact avec la couche isolante d'isolation de contact (140).

6. Dispositif de circuit intégré (10) selon la revendication 5, dans lequel la couche d'isolation d'isolation de contact (140) et le pont fusionné de contact (CM) sont espacés l'un de l'autre dans la seconde direction horizontale.

7. Dispositif de circuit intégré (10) selon toute revendication précédente, dans lequel le premier contact source/drain (CA1) et le rail d'alimentation via (130) ne sont pas en contact direct l'un avec l'autre au niveau des parois latérales respectives et sont connectés électriquement l'un à l'autre par le pont fusionné de contact (CM) sur une surface supérieure du rail d'alimentation via (130).

8. Dispositif de circuit intégré (10) selon une quelconque revendication précédente, comprenant en outre :
une électrode de grille (125) s'étendant longitudinalement dans la seconde direction horizontale sur la paire de régions actives de type ailette (FA) ; et
une couche de recouvrement de grille (127) sur l'électrode de grille (125),
dans lequel une surface inférieure du pont fusionné de contact (CM) est espacée d'une surface supérieure de l'électrode de grille (125) dans la direction verticale.

9. Dispositif de circuit intégré (10) de la revendication 8, comprenant en outre une paire d'empilements de nanofeuilles (NS) entre la paire de régions actives de type ailette (FA) et l'électrode de grille (125),
dans lequel, en vue de dessus, le pont fusionné de contact (CM) ne chevauche pas la paire d'empilements de nanofeuilles (NS).

10. Dispositif de circuit intégré (20) comprenant :
une structure d'isolation arrière supérieure (210) incluant une partie saillante et une structure d'isolation arrière inférieure (220) sur une surface inférieure de la structure d'isolation arrière supérieure (210) opposée à la partie saillante ;
une paire de régions actives de type ailette (FA) sur la partie saillante de la structure d'isolation arrière supérieure (210) et s'étendant longitudinalement dans une première direction horizontale ;
une couche d'isolation de dispositif (103) sur des parois latérales opposées de chacune de la paire de régions actives de type ailette (FA) ;
une paire d'empilements de nanofeuilles (NS) sur des premières portions de la paire de régions actives de type ailette (FA) ;
une électrode de grille (125) s'étendant longitudinalement sur la paire de régions actives de type ailette (FA) pour s'intersecter avec la paire de régions actives de type ailette (FA) et s'étendant sur la paire d'empilements de nanofeuilles (NS) ;
une paire de régions source/drain (SD) sur des secondes portions de la paire de régions actives de type ailette (FA) ;
une couche d'isolation intermédiaire (110) sur la paire de régions source/drain (SD) et la couche d'isolation du dispositif (103) ;
un rail d'alimentation via (130) s'étendant longitudinalement dans la première direction horizontale entre la paire de régions actives de type ailette (FA) et s'étendant à travers la couche d'isolation intermédiaire (110) et la couche d'isolation du dispositif (103) dans une direction verticale qui est perpendiculaire à la première direction horizontale ;
une paire de contacts source/drain (CA) espacés l'un de l'autre avec le rail d'alimentation via (130) entre eux pour établir le contact avec la paire de régions source/drain (SD) ;
un pont de contact (CM2) sur le rail d'alimentation via (130) et un premier contact source/drain (CA1) de la paire de contacts source/drain (CA) ;
une structure via (160) sur un second contact source/drain (CA2) de la paire de contacts source/drain (CA) ; et
un câblage de rail d'alimentation (230) s'étendant à travers la structure d'isolation arrière supérieure (210) et la structure d'isolation arrière inférieure (220) dans la direction verticale et entrant en contact avec le rail d'alimentation via (130),
dans lequel l'angle (D2) entre une surface inférieure et une paroi latérale du pont de contact (CM2) est aigu, la surface inférieure du pont de contact (CM2) étant située sur une surface supérieure du rail d'alimentation via (130), et dans lequel un angle (D3) entre une surface inférieure et une paroi latérale de la structure via (160) est obtus, la surface inférieure de la structure via (160) étant située sur une surface supérieure du second contact source/drain (CA2), et
dans lequel une épaisseur (CM2T) du pont de contact (CM2) dans la direction verticale est sensiblement égale à une épaisseur (160T) de la structure via (160) dans la direction verticale.

11. Dispositif de circuit intégré (20) selon la revendication 10, dans lequel le premier contact source/drain (CA1) et le pont de contact (CM2) présentent une structure unitaire qui est exempte de surface limite entre eux.
